# EUROPEAN PATENT APPLICATION

(11) **EP 1 968 070 A1**
(43) Date of publication of application: **10.09.2008**
(21) Application number: 08102346.7
(22) Date of filing: 06.03.2008
(51) Int. Cl.: G11C 7/10

(54) **Memory controller**

(30) Priority: 08.03.2007 KR 20070023082; 25.02.2008 KR 20080016779
(71) Applicant: Samsung Electronics Co., Ltd., Suwon-si Gyeonggi-do (KR)
(72) Inventor: Koo, Tae Woon 108-706, Gangnam Apt., Suwon-si, Gyeonggi-do (KR); Lee, Yoon Tae 524-503, Samsung-5th, Yongin-si Gyeonggi-do (KR); Kim, Kyu Sung 606-1501, Gangnam-maeul, Yongin-si Gyeonggi-do (KR); Park, Young Jin, Bucheon-si Gyeonggi-do (KR)
(74) Representative: Walaski, Jan Filip

(57) **Abstract**

A memory controller that can be used for timing purposes of an SDRAM includes a ring oscillator (110) to generate and to output at least one oscillation clock, an oscillation counter (120) to count the output oscillation clocks, a sampler (130) to receive the reference clock so as to sample oscillation clocks count values during a period of the reference clock, and a phase value output unit (140) to output the sampled oscillation clock count values as a phase value of the reference clock. Thereby, the memory controller can detect the phase value using only two periods of the reference clock, and reduce the initial operation time of a system.

## Description

The present invention relates generally to a memory controller, and more particularly, a memory controller detecting the phase of an input clock.

A memory controller generally includes a phase detector, a delay controller, and a delay processor, and controls a double data rate (DDR). An example of the memory controller is disclosed in Korean Patent Publication No. 2006-83011.

The phase detector includes a delay line having a plurality of delay elements connected in series, each of which is a delay minimum unit, two delay elements, and two flip-flops generating a first phase signal phase1 and a second phase signal phase2 in order to detect the phase of a reference clock. The phase detector performs two functions: receiving the reference clock to detect the phase of the reference clock, and detecting the phase of the reference clock passing through the delay line to detect how many delay elements are required for the reference clock.

The delay controller varies the number of the delay elements of the delay line to determine whether the first phase signal phase1 is phase-locked with the second phase signal phase2. The delay controller determines that the number of the delay elements of the delay line is a phase value of the reference clock when the phase lock occurs. This phase value of the reference clock is sent to the delay processor, and thereby is used to control the timing of a read operation and a write operation for the DDR memory.

However, this conventional technique requires a long time from initial startup of a system to the phase lock due to the delay line of the phase detector. Because a long time is required to detect the phase value of the reference clock, the startup time of the system increases.

Aspects of the present invention provide a memory controller capable of detecting the phase value of a reference clock within a short time.

According to an aspect of the present invention, a memory controller is provided. The memory controller includes a ring oscillator to generate and to output at least one oscillation clock, an oscillation counter to count the output oscillation clocks, a sampler to receive a reference clock so as to sample a number of the counted oscillation clocks during a period of the reference clock, and a phase value output unit to output the sampled number of oscillation clocks as a phase value of the reference clock.

According to another aspect of the present invention, the ring oscillator includes an odd number of inverters connected in a ring form.

According to another aspect of the present invention, the period of the reference clock is detected using a count value counted by the oscillation counter.

According to another aspect of the present invention, the sampler may sample the number of the counted oscillation clocks for a time from an initial rising edge of the reference clock to a next rising edge.

According to another aspect of the present invention, a memory controller is provided that varies a reference clock by a delay value so as to output the varied reference clock is provided. The memory controller includes a phase detector to detect a phase of the reference clock using a ring oscillator, a delay controller to compare a phase value detected through the phase detector with a preset phase value and to adjust the phase value output according to whether the detected phase value matches the preset phase value, and a delay processor to delays the reference clock by a delay value determined by the phase value input from the delay controller.

According to another aspect of the invention, the ring oscillator generates and outputs at least one oscillation clock, and the phase detector includes the ring oscillator, an oscillation counter to count the output oscillation clocks, a sampler to receive a reference clock to sample a number of the counted oscillation clocks during a period of the reference clock, and a phase value output unit to output the sampled number of oscillation clocks as a phase value of the reference clock. Additional aspects and/or advantages of the invention will be set forth in part in the description which follows and, in part, will be obvious from the description, or may be learned by practice of the invention.

These and/or other aspects and advantages of the invention will become apparent and more readily appreciated from the following description of the embodiments, taken in conjunction with the accompanying drawings of which:
FIG. 1 is a schematic control block diagram illustrating a conventional memory controller;
FIG. 2 is a schematic control block diagram of the phase detector illustrated in FIG. 1;
FIG. 3 is a schematic control block diagram illustrating a memory controller according to an embodiment of the present invention;
FIG. 4 is a schematic control block diagram of the phase detector illustrated in FIG. 3;
FIG. 5 is a view illustrating an internal configuration of the ring oscillator illustrated in FIG. 4; and
FIG. 6 is a timing diagram of the main components of FIG. 4.

Reference will now be made in detail to the present embodiments of the present invention, examples of which are illustrated in the accompanying drawings, wherein like reference numerals refer to the like elements throughout. The embodiments are described below in order to explain the present invention by referring to the figures.

In general, a memory is a recording medium capable of writing and reading data. For example, a dynamic random access memory (DRAM) performs read or write operation of data according to a control signal sent from a memory controller, and is widely used due to a simple structure and high-density integration. Typically, the memory is divided into a double data rate (DDR) memory and a single data rate (SDR) memory according to a transmission quantity of data based on a clock.

The SDR memory writes or reads data at a rising edge of the clock, and transfers data at a speed at which the data can be read or written once per clock period. In contrast, the DDR memory writes or reads data at a rising edge of the clock as well as at a falling edge of the clock, and transfers data at a speed at which the data can be read or written twice per clock period. In the DDR memory, because the data is transferred at double speed such that it can be read or written twice per clock period, also referred to as clock cycle, an effective data window capable of stably writing or reading the data is considerably narrower than that of the SDR memory.

The memory controller and the DDR memory transfers and receives a control signal for instructing timing of the read or write operation of the data together with the data. The control signal is generated by delaying a clock at a predetermined speed in order to accurately designate the timing at which a designated operation will be performed.

A signal transferred and received between the memory controller and the DDR memory is delayed for a predetermined time depending on surrounding environmental influences, such as PVT (process, voltage, and temperature), and then is transferred to the DDR memory. The memory controller employs a delay compensation circuit (DCC) in order to precisely delay and transfer the clock for a predetermined time such that rising and falling edges of the clock are located within the effective data window for receiving the data based on the delay time of the control signal transferred to the DDR memory.

The DCC is mounted on the memory controller that interfaces an application specific integrated circuit (ASIC) and the DDR memory. The DCC adjusts the timing of the control signal that is transferred from the memory controller to the DDR memory.

As the speed of systems continues to increase, a frequency of the systems is increasing as well, and thus the effective data window is becoming narrower. In order to accurately read or write the data on these narrower effective data windows, the DCC is indispensable for the memory controller. When the DCC is employed, the memory controller can delay the control signal for the read operation, which is received from the DDR memory, to allow the ASIC to accurately recognize the data in the case of the read operation, and delay and transfer the control signal such that the memory can accurately recognize the data in the case of the write operation.

In order to delay the control signal to allow the memory to accurately recognize the data within the narrow effective data window, the DCC should have good performance. To this end, the delay time of a delay element for the DCC should be short, so that the delay time can be adjusted precisely. For this reason, the number of delay elements required to delay the clock for at least one clock period is considerably increased. For example, where the DCC is employed in a 100 MHz system, and where a delay element is used in which one DCC has a delay value of 100 ps, the number of delay elements constituting one delay line required to delay the clock period amounts to at least 100.

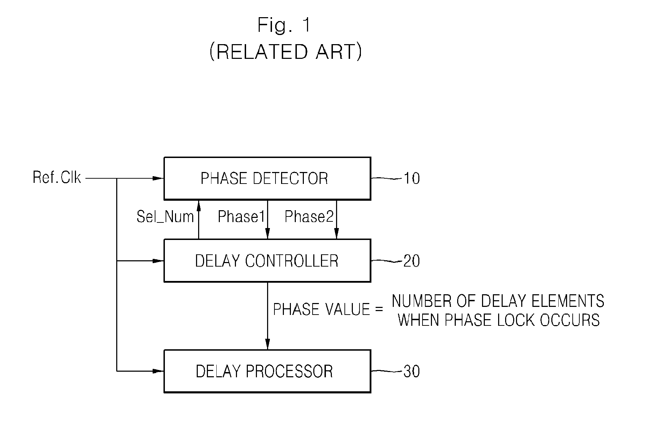

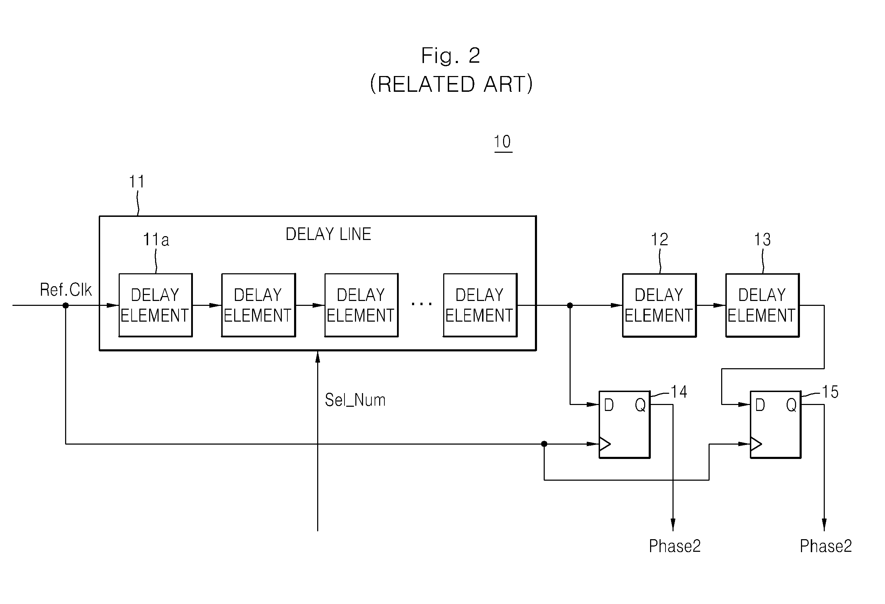

FIG. 1 is a schematic control block diagram of a conventional memory controller. FIG. 2 is a schematic control block diagram of the phase detector shown in FIG. 1. As shown in FIG. 1, the conventional memory controller includes a phase detector 10 detecting the phase of an input reference clock signal 2, a delay controller 20 adjusting delay of the phase detector 10, and a delay processor 30 delaying read and write signals by a delay value designated from the phase detector 10.

The phase detector 10, as shown in FIG. 2, includes a delay line 11 having a plurality of delay elements 11a, each of which is a delay minimum unit, connected in series, two delay elements 12 and 13 connected in series to a trailing terminal of the delay line 11, and two flip-flops 14 and 15 generating a first phase signal phase1 and a second phase signal phase2 in order to detect the phase value of a reference clock Ref. Clk.

The phase detector 10 receives the reference clock Ref. Clk to detect a period of the reference clock Ref. Clk using the delay line 11, the two delay elements, and the two flip-flops 14 and 15. The phase detector 10 also detects a phase of the reference clock Ref. Clk passing through the delay line 11 to detect how many delay elements 11a are required for the reference clock Ref. Clk.

The delay controller 20 determines whether a phase lock occurs using the outputs of the phase detector 10 (the phase signals phase1 and phase2). If the phase lock does not occur, the delay controller 20 adjusts a delay control signal Sel_Num output to the phase detector 10 until the phase lock occurs, and thereby increases and decreases the number of delay elements 11a participating in the delay at the delay line 11 of the phase detector 10. The delay controller 20 adjusts the delay control signal Sel_Num to search for a point of time (or a phase-locked point) at which an output of the first phase signal phase1 is "high," and an output of the second phase signal phase2 is "low." When the phase lock occurs, a value of the delay control signal Sel_Num is output as the phase value.

When process, voltage, and temperature (PVT) are varied, the delay values of the delay elements 11a are varied. Due to this variation, the delay control signal Sel_Num, which is phase-locked at each clock period, is varied together. As a result, the phase values are varied, and the variation of the PVT is corrected.

The conventional method described above requires a long time from initial operation of the system to the phase lock due to the delay line 11 of the phase detector 10. Thus, much time is taken to detect the phase value of the reference clock Ref. Clk, so that an initial operation time of the system becomes long. After the initial operation of the system, the output of the first phase signal phase1 and the output of the second phase signal phase2 continue not to be phase-locked with each other until the value of the delay control signal Sel_Num is "N," and then are phase-locked with each other when the output of the first phase signal phase1 is converted into "high" and the output of the second phase signal phase2 is converted into "low." N clock periods are required to detect the phase value of the reference clock. Thus, it is necessary to reduce the initial operation time of the system by detecting the phase value of the reference clock within a shorter time.

According to aspects of the present invention, a number of oscillation clocks is counted during a period of the reference clock using a ring oscillator that generates and outputs the oscillation clock, and is output as the phase value of the reference clock. The phase value of the reference clock may be more quickly detected, so that the initial operation time of the system can be reduced.

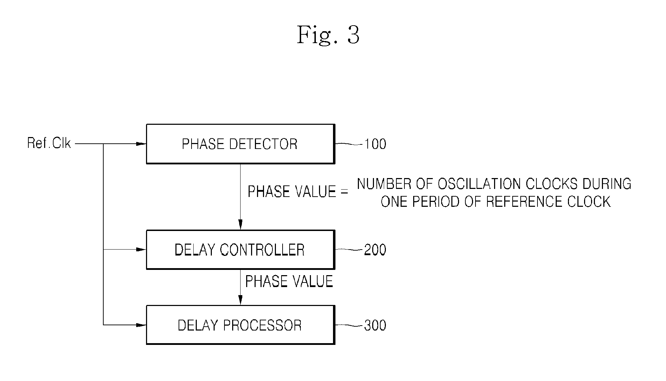

FIG. 3 is a schematic control block diagram illustrating a memory controller according to an embodiment of the present invention. The memory controller includes a phase detector 100, a delay controller 200, and a delay processor 300. The phase detector 100 detects the phase of a reference clock using a ring oscillator. The delay controller 200 controls operations of comparing a phase value detected through the phase detector 100 with a preset phase value, outputting the detected phase value with no change when the detected phase value is matched with the preset phase value, and correcting and outputting the detected phase value when the detected phase value is not matched with the preset phase value. The delay processor 300 receives the phase value from the delay controller 200 and processes read operation and write operation by delaying the reference clock by a designated delay value. According to other aspects of the invention, the memory controller may include additional and/or different components. Similarly, the functionality of two or more of the above components may be combined into a single unit.

The memory controller may be incorporated within a computing apparatus in conjunction with, or as part of, a memory. The computing apparatus may be any apparatus having a memory, such as a desktop computer, a laptop computer, a server, a mobile telephone, a personal digital assistant, a personal entertainment device, a home entertainment device, or the like.

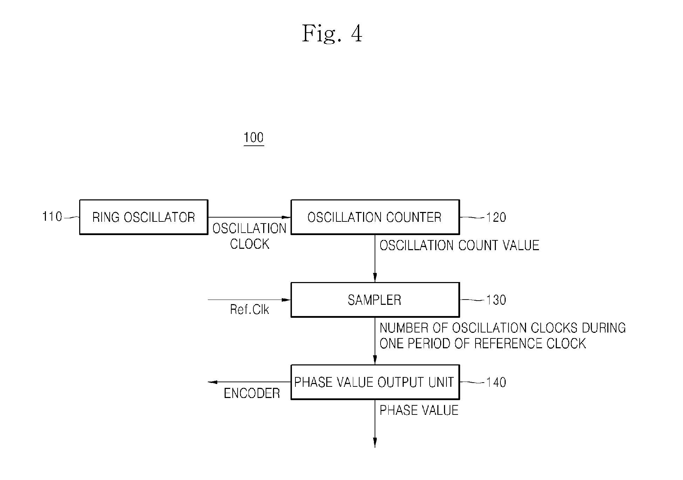

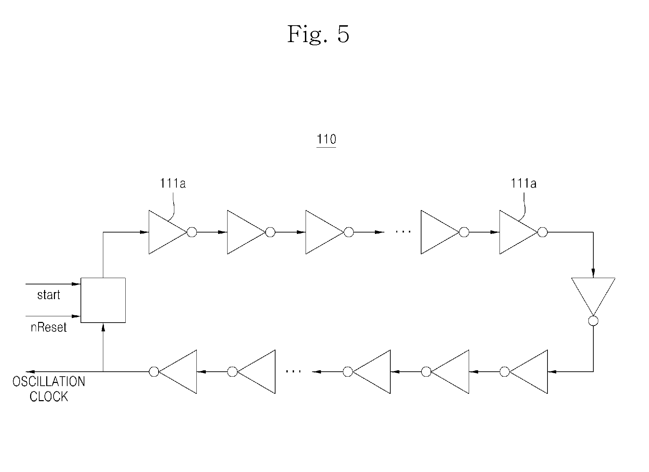

As shown in FIG. 4, the phase detector 100 includes a ring oscillator 110, an oscillation counter 120, a sampler 130, and a phase value output unit 140. The ring oscillator 110, as shown in FIG. 5, has an odd number of inverters 111a connected in a ring form. The ring oscillator 110 oscillates by connecting the plurality of inverters 111a to form a positive feedback loop. The ring oscillator 110 is free running to output the oscillation clock when nReset and Start signals have a logic value of "high." A period of the oscillation clock is identical to a delay time of two inverters.

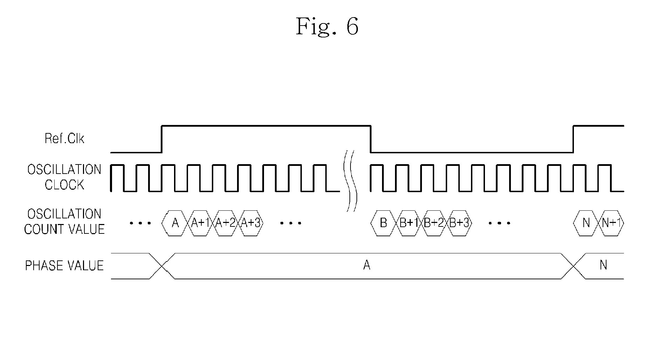

The oscillation counter 120 is a counter that uses the output of the ring oscillator 110 (the oscillation clock) as an input clock. As shown in FIG. 6, the oscillation counter 120 counts the oscillation clock, in other words counts the number of oscillation clock cycles.

The sampler 130 samples an oscillation count value during a period of the reference clock using the reference clock Ref. Clk as an input clock. The sampler 130 samples the number of oscillation clocks counted by the oscillation counter 120 for a time from an initial rising edge of the reference clock to the next rising edge, as shown in FIG. 6. In FIG. 6, the sampled results correspond to "A" and "N."

The phase value output unit 140 outputs the number of oscillation clocks, which is sampled by the sampler 130, as a phase value of the reference clock. In FIG. 6, the output result corresponds to "N-A." An N-A cycle of the oscillation clock of the ring oscillator 110 shows that the N-A cycle forms one period of the reference clock Ref. Clk.

The delay controller 200 controls operations of comparing the phase value detected through the phase detector 100 with a preset phase value, outputting the detected phase value intact when the detected phase value is matched with the preset phase value, and correcting and outputting the detected phase value when the detected phase value is not matched with the preset phase value. In the ring oscillator 110, the period of the oscillation clock is varied according to variation of the PVT, and thus the phase value is varied. The delay controller 200 receives the phase value detected through the phase detector 100 and compares the received phase value with a pre-defined phase value. The delay controller 200 outputs the detected phase value to the delay processor 300 with no change when the received phase value is matched with the pre-defined phase value. The delay controller 200 outputs a phase value, which is subjected to PVT correction to the detected phase value, to the delay processor 300 when the received phase value is not matched with the pre-defined phase value.

The delay processor 300 delays the reference clock by a delay value designated by the phase value output from the delay controller 200, and thereby processes a read operation and a write operation of the memory.

As described above in detail, according to aspects of the present invention, the memory controller includes the ring oscillator generating and outputting the oscillation clocks, the oscillation counter counting the output oscillation clocks, the sampler receiving the reference clock to sample the number of oscillation clocks counted during a period of the reference clock, and the phase value output unit outputting the sampled number of oscillation clocks as the phase value of the reference clock, so that the memory controller can detect the phase value using only two periods of the reference clock, and reduce the startup time of a system.

Although a few embodiments of the present invention have been shown and described, it would be appreciated by those skilled in the art that changes may be made in this embodiment without departing from the principles of the invention, the scope of which is defined in the claims.

## Claims

1. Apparatus for controlling a memory comprising:
a ring oscillator for generating and outputting at least one oscillation clock;
an oscillation counter for counting the at least one oscillation clock;
a sampler for receiving a reference clock so as to sample a number of the counted oscillation clocks during a period of the reference clock; and
a phase value output unit for outputting the sampled number of oscillation clocks as a phase value of the reference clock.

2. The apparatus according to claim 1, wherein the ring oscillator includes an odd number of inverters connected in a ring form.

3. The apparatus according to claim 1 or 2, wherein the period of the reference clock is detected using a count value counted by the oscillation counter.

4. The apparatus according to claim 1, 2 or 3 wherein the sampler is arranged to sample the number of the counted oscillation clocks for a time from a first rising edge of the reference clock to a next rising edge of the reference clock.

5. A memory controller for varying a reference clock by a delay value so as to output the varied reference clock, the memory controller comprising:
a phase detector for detecting a phase of the reference clock using a ring oscillator;
a delay controller for comparing a phase value detected through the phase detector with a preset phase value and for adjusting the phase value according to whether the detected phase value matches the preset phase value; and
a delay processor for delaying the reference clock by the delay value determined by the phase value input from the delay controller.

6. The memory controller according to claim 5, wherein the phase detector comprises the apparatus according to any one of claims 1 to 4.

7. A method of controlling a memory, comprising:
detecting a phase of a reference clock using a ring oscillator;
comparing the detected phase with a preset reference value;
outputting the detected phase with no change, if the detected phase matches the preset reference value, so as to control a memory; and
correcting the phase value and outputting the corrected phase value, if the detected phase does not match the preset reference value, so as to control the memory.

8. A computing apparatus comprising:
a computer;
a memory to store data used by the computer; and
a memory controller according to claim 5 or 6, wherein the delay processor is arranged to delay the reference clock by a delay value determined based on the phase value so as to control read and write operations of the memory.

9. The apparatus according to claim 8, wherein the memory controller is arranged to detect the phase value using two periods of the reference clock so as to reduce a startup time for the computer.

10. A computing apparatus comprising:
a memory; and
a memory controller for controlling the memory using a varied reference clock and for detecting a phase value of the reference clock using only two periods of the reference clock, so as to reduce an initial startup time of the apparatus.
